# EUROPÄISCHE PATENTANMELDUNG

(11) **EP 2 322 476 A1**
(43) Veröffentlichungstag der Anmeldung: **18.05.2011**
(21) Anmeldenummer: 09176051.2
(22) Anmeldetag: 16.11.2009
(51) Int. Cl.: C01B 31/02, C01B 33/025, F27B 3/08, F27B 3/20, F27D 11/08, F27D 99/00

(54) **Neues Verfahren zur Herstellung von Silicium**

(71) Anmelder: Evonik Degussa GmbH, 45128 Essen (DE)
(72) Erfinder: Karl, Alfons, Dr., 63584 Gründau (DE); Lang, Jürgen Erwin, Dr., 76229 Karlsruhe (DE); Rauleder, Hartwig, Dr., 79618 Rheinfelden (DE); Frings, Bodo, Dr., 33758 Schloß Holte (DE)

(57) **Zusammenfassung**

Die vorliegende Erfindung betrifft ein verbessertes Verfahren zur Herstellung von Silicium, bevorzugt Solarsilicium, unter Verwendung neuartiger hochreiner Graphitformteile, insbesondere Graphitelektroden sowei ein technisches Verfahren zur deren Herstellung der neuartigen Graphitformteile.

## Beschreibung

Die vorliegende Erfindung betrifft ein verbessertes Verfahren zur Herstellung von Silicium, bevorzugt Solarsilicium, unter Verwendung neuartiger hochreiner Graphitformteile, insbesondere Graphitelektroden sowei ein technisches Verfahren zur deren Herstellung.

Es ist bekannt Solarsilicium aus Siliciumdioxid und Kohlenstoff bei hoher Temperatur herzustellen. Dieses Verfahren wird bevorzugt in einem Lichtbogenofen mit Graphitelektroden durchgeführt. Da das Solarsilicium eine sehr hohe Reinheit aufweisen muss, dürfen durch die Elektroden oder andere Ofenbestandteile keine Verunreinigungen in die Siliciumschmelze eingetragen werden. Neben den Elektroden werden daher auch viele andere Bestanteile des Ofens aus Graphit hergestellt.

Hauptbestandteil von Graphitelektroden ist üblicher Weise Petrolkoks, der aus Destillationsrückständen des Erdöls hergestellt wird. Daneben wird auch Graphit, Steinkohlenkoks und Ruß eingesetzt. Als Bindemittel dienen Peche oder auch Phenol- und Furfuralharze. Die Füllstoffe werden mit den Bindemitteln intensiv und homogen vermischt und in Extrudern oder in isostatischen Pressen zu Grünkörpern geformt. Danach erfolgt das Glühen der Grünkörper unter Sauerstoffabschluss bei Temperaturen von 600-1200 °C und die Graphitisierung im Temperaturbereich von 1800-3000 °C, wobei die Reinheit des Werkstoffes erheblich zunimmt, da nahezu alle Verunreinigungen verdampfen. Die Eigenschaften der Elektrode werden dabei bestimmt durch:
- die Rohstoffauswahl, d.h. Art und Korngröße + deren Anteile in der Rezeptur,
- der Art, der Menge und des Zustandes des Bindemittels,
- den Aufheizraten und Temperaturen beim Glühen und Graphitisieren
- dem Imprägnieren der geglühten und graphitisierten Werkstoffe.

Neben dem Elektrodenmaterial wird bei der Herstellung von Solarsilicium aus Siliciumdioxid ein Reduktionsmittel benötigt. Hierzu ist bekannt Zucker als Reduktionsmittel mit einem geringen Anteil an Verunreingungen (US 4,294,811, WO 2007/106860) oder als Bindemittel (US 4,247,528) einzusetzen. Der Zucker wird dabei in-situ im Hochofen oder in einem vorgeschalteten Schritt pyrolysiert.

So offenbart die US 5,882,726 ein Verfahren zur Herstellung einer Kohlenstoff-Kohlenstoff-Zusammensetzung, wobei eine Pyrolyse eines niedrig schmelzenden Zuckers durchgeführt wird.

In der GB 733 376 ist ein Verfahren zur Reinigung einer Zuckerlösung sowie zur Pyrolyse bei 300 bis 400 °C zu entnehmen.

Es ist ebenfalls bekannt, Zucker bei hoher Temperatur zu pyrolysieren, um eine elektronenleitfähige Substanz zu erzeugen (WO 2005/051840).

Bei der großtechnischen Pyrolyse von Kohlenhydraten kann es jedoch zu Problemen durch Karamelisierung und Schaumbildung kommen, was die Prozessführung und den Prozessablauf erheblich stören kann.

Der vorliegenden Erfindung lag daher die Aufgabe zugrunde, das Verfahren zur Herstellung von Silicium durch Reduktion von Siliciumdioxid mit Kohlenstoff zu verbessern. Eine spezielle Aufgabe bestand darin die apparativen Gegebenheiten derart zu verbessern, dass die Kosten für die Herstellung der benötigten hochreinen Apparatebestandteile gesenkt, gleichzeitig aber die Verunreinigungen auf zumindest gleichem Level wie bei den bekannten Verfahren gehalten wird. Eine weitere spezielle Aufgabe war es neuartige Materialen für hochreine Apparatebestandteile sowie ein Verfahren zu deren Herstellung zu entwickeln.

Weitere nicht explizit genannte Aufgaben ergeben sich aus dem Gesamtzusammenhang der nachfolgenden Beschreibung, Beispiele und Ansprüche.

Diese Aufgaben werden erfindungsgemäß entsprechend den Angaben in den Patentansprüchen, der nachfolgenden Beschreibung und den Beispielen gelöst.

So wurde in überraschender Weise gefunden, dass durch Pyrolyse von Kohlehydraten Kohlenstoffmaterialien erhalten werden können aus denen hochreine Graphitformteile für Hochöfen, insbesondere Lichtbogenöfen erhalten werden können. Kohlehydrate, bevorzugt Zucker, als Ausgangsmaterial weisen den Vorteil auf, dass sie annähernd überall auf der Welt in ausreichenden Mengen mit annähernd gleichem Reinheitsgrad erhältlich sind. Ferner weist Zucker von natur aus sehr niedrige Verunreinigungen an Bor und Phosphor auf. Somit wird der Reinigungsaufwand der Edukte im Vergleich zu den im Stand der Technik verwendeten Edukten deutlich reduziert. Schließlich ist Zucker ein sehr preiswerter Rohstoff, der im Vergleich zu fossilen Rohstoffen nachwachsend und daher auch in Zukunft noch in hinreichenden Mengen verfügbar ist.

In einer speziellen Ausführungsform wird das Kohlehydrat, bevorzugt der Zucker, in Gegenwart eines Siliciumoxids, vorzugsweise SiO₂, insbesondere Fällungskieselsäure und/oder pyrogen hergestellte Kieselsäure und/oder Kieselgel, pyrolysiert. Dieses Verfahren weist zum einen den Vorteil auf, dass durch das Silciumoxid der Schaumbildungseffekt bei der Pyrolyse unterdrückt werden und somit ein industrieller Prozess zur Pyrolyse von Kohlehydraten in einfacher und wirtschaftlicher Weise nun auch ohne störende Schaumbildung betrieben werden kann.

Darüber hinaus wurde bei der Durchführung des erfindungsgemäßen Verfahrens auch eine Reduzierung der Karamellbildung beobachtet.

Ferner hat sich gezeigt, dass bei der Pyrolyse von Kohlehydraten in Gegenwart von Siliciumoxiden, bevorzugt Siliciumdioxid, ein Pyrolyseprodukt (nachfolgend auch Pyrolysat genannt) erhalten wird, welches besonders vorteilhaft zu Graphitformteilen, bevorzugt Graphitelektroden weiterverarbeitet werden kann. Man erhält dadurch Graphitelektroden, welche mit Siliciumoxiden, bevorzugt Siliciumdioxid, und/oder Siliciumcarbid dotiert sind. Ohne an eine bestimte Theorie gebunden zu sein sind die Anmelder der Ansicht, dass durch die Dotierung die Bildung von Silicium in der Schmelze des Lichbogenofens gegenüber der Bildung von Siliciumcarbid bevorzugt wird und somit eine höhere Ausbeute an Silicium mit zudem höherem Reinheitsgrad erreicht werden kann.

Gegenstand der vorliegenden Erfindung ist daher ein Verfahren zur Herstellung von Silicium, bevorzugt Solarsilicium durch Reduktion von Siliciumdioxid mit Kohlenstoff, dadurch gekennzeichnet, dass es in einem Lichtbogenofen durchgeführt wird und dass zumindest Teile des Ofens oder der Elektroden aus einem Graphitmaterial hergestellt werden, welches wiederum aus einem Kohlenstoffmaterial erhalten werden, welches durch Pyrolyse von zumindest einem Kohlenhydrat, bevorzugt zumindest einem Zucker gewonnen wird.

Die restlichen Teile der Graphitformteile können aus den üblicher Weise zur herstellung solcher Teile verwendeten Materialien bestehen, vorzugsweise sind diese Materialien in hochreiner Form, so dass die Graphitformteile bevorzugt das unten definierte Verunreinigungsspektrum aufweisen.

Ebenfalls Gegenstand der vorliegenden Erfindung ist das zuvor beschriebene Verfahren, jedoch dadurch gekennzeichnet, dass die Pyrolyse des Kohlenhydrats in Gegenwart zumindest eines Siliciumoxids durchgeführt wird.

Gegenstand der vorliegenden Erfindung sind auch Graphitformteile, bevorzugt Formteile eines Lichtbogenofens, besonders bevorzugt Graphitelektroden, dadurch gekennzeichnet, dass sie mit Silciumoxiden, bevorzugt Siliciumdioxid, und/oder SiC dotiert sind. In einer besonderen Ausführungsform handelt es sich hierbei um hochreine Graphitformteile, welche das nachfolgende Verunreinigungsprofil aufweisen:
a. Aluminium kleiner gleich 5 ppm bevorzugt oder zwischen 5 ppm und 0,0001 ppt, insbesondere zwischen 3 ppm bis 0,0001 ppt, bevorzugt zwischen 0,8 ppm bis 0,0001, ppt, besonders bevorzugt zwischen 0,6 ppm bis 0,0001 ppt, noch besser zwischen 0,1 ppm bis 0,0001 ppt, ganz besonders bevorzugt zwischen 0,01 ppm und 0,0001 ppt, wobei noch bevorzugter 1 ppb bis 0,0001 ppt ist,
b. Bor unter 10 ppm bis 0,0001 ppt, insbesondere im Bereich von 5 ppm bis 0,0001 ppt, bevorzugt im Bereich von 3 ppm bis 0,0001 ppt oder besonders bevorzugt im Bereich von 10 ppb bis 0,0001 ppt, noch bevorzugter im Bereich von 1 ppb bis 0,0001 ppt
c. Calcium kleiner gleich 2 ppm, bevorzugt zwischen 2 ppm und 0,0001 ppt, insbesondere zwischen 0,3 ppm bis 0,0001 ppt, bevorzugt zwischen 0,01 ppm bis 0,0001 ppt, besonders bevorzugt zwischen 1 ppb bis 0,0001 ppt,
d. Eisen kleiner gleich 20 ppm, bevorzugt zwischen 10 ppm und 0,0001 ppt, insbesondere zwischen 0,6 ppm und 0,0001 ppt, bevorzugt zwischen 0,05 ppm bis 0,0001 ppt, besonders bevorzugt zwischen 0,01 ppm bis 0,0001 ppt, und ganz besonders bevorzugt 1 ppb bis 0,0001 ppt;
e. Nickel kleiner gleich 10 ppm, bevorzugt zwischen 5 ppm und 0,0001 ppt, insbesondere zwischen 0,5 ppm und 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt
f. Phosphor kleiner 10 ppm bis 0,0001 ppt, bevorzugt zwischen 5 ppm bis 0,0001 ppt, insbesondere kleiner 3 ppm bis 0,0001 ppt, bevorzugt zwischen 10 ppb bis 0,0001 ppt und ganz besonders bevorzugt zwischen 1 ppb bis 0,0001 ppt
g. Titan kleiner gleich 2 ppm, bevorzugt kleiner gleich 1 ppm bis 0,0001 ppt, insbesondere zwischen 0,6 ppm bis 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt.
h. Zink kleiner gleich 3 ppm, bevorzugt kleiner gleich 1 ppm bis 0,0001 ppt, insbesondere zwischen 0,3 ppm bis 0,0001 ppt, bevorzugt zwischen 0,1 ppm bis 0,0001 ppt, besonders bevorzugt zwischen 0,01 ppm bis 0,0001 ppt und ganz besonders bevorzugt zwischen 1 ppb bis 0,0001 ppm.

Die Bestimmung von Verunreinigungen kann beispielsweise - aber nicht ausschließlich - mittels ICP-MS/OES (Induktionskopplungsspektrometrie - Massenspektrometrie/optische Elektronenspektrometrie) sowie AAS (Atomabsorptionsspektroskopie) erfolgen.

Die erfindungsgemäßen Graphitformteile weisen bevorzugt ein Verhältnis von Kohlenstoff zu Silicium (gerechnet als Siliciumdioxid) von 400 zu 0,1 bis 0,4 zu 1 000, besonders bevorzugt von 400 : 0,4 bis 4 : 10; ganz besonders bevorzugt von 400 : 2 bis 4 : 1,3 und insbesondere von 400 : 4 bis 40 : 7 auf.

Das erfindungsgemäße Verfahren zeichnet insbesondere dadurch aus, dass die Graphitformteile aus einem Kohlenstoffmaterial hergestellt werden, welches durch Pyrolyse von zumindest einem Kohlenhydrat, bevorzugt zumindest einem Zucker gewonnen wurde, wobei in bevorzugten Varianten die Pyrolyse in Gegenwart zumindest eines Siliciumoxids durchgeführt wurde.

Das erfindungsgemäße Verfahren erlaubt es die Pyrolyse des Kohlenhydrats bei sehr niedrigen Temperaturen durchzuführen. So ist es vorteilhaft, da besonders Energie sparend (Tieftemperaturfahrweise), im erfindungsgemäßen Verfahren die Pyrolysetemparatur von 1600 °C bis 1700°C auf unter 800°C abzusenken. So betreibt man das erfindungsgemäße Verfahren in einer ersten bevorzugten Ausführungsform bevorzugt bei einer Temperatur von 250 °C bis 800 °C, besonders bevorzugt bei 300 bis 800 °C, ganz besonders bevorzugt bei 350 bis 700 °C und speziell bevorzugt bei 400 bis 600 °C. Dieses Verfahren ist äußerst energieeffizient und hat zudem den Vorteil, dass die Karamellbildung reduziert und die Handhabung der gasförmigen Reaktionsprodukte erleichtert wird.

Es ist jedoch prinzipiell in einer zweiten bevorzugten Ausführungsform auch möglich die Reaktion zwischen 800 und 1700 °C, besonders bevorzugt zwischen 900 und 1600 °C, ganz besonders bevorzugt bei 1000 bis 1500 °C und insbesondere bei 1000 bis 1400 °C durchzuführen. Hierbei wird in der Regel ein stärker Graphit-haltiges Pyrolyseprodukt erhalten, welches den nachfolgenden Aufwand für die graphitisierung reduziert oder entfallen lässt.

Das erfindungsgemäße Verfahren führt man vorteilhaft unter Schutzgas und/oder vermindertem Druck (Vakuum) aus. So führt man das erfindungsgemäße Verfahren vorteilhaft bei einem Druck von 1 mbar bis 1 bar (Umgebungsdruck), insbesondere von 1 bis 10 mbar, durch. Zweckmäßigerweise wird die verwendete Pyrolyseapparatur vor Beginn der Pyrolyse getrocknet und durch Spülen mit einem Inertgas, wie Stickstoff oder Argon oder Helium, praktisch frei von Sauerstoff gespült. Die Pyrolysedauer beim erfindungsgemäßen Verfahren beträgt in der Regel zwischen 1 Minute und 48 Stunden, vorzugsweise zwischen 1/4 Stunde und 18 Stunden, insbesondere zwischen 1/2 Stunde und 12 Stunden bei besagter Pyrolysetemperatur, dabei kann die Aufheizzeit bis zum Erreichen der gewünschten Pyrolysetemperatur zusätzlich in gleicher Größenordnung liegen, insbesondere zwischen 1/4 Stunde und 8 Stunden. Das vorliegende Verfahren führt man in der Regel batchweise aus; man kann es aber auch kontinuierlich ausführen.

Ein erfindungsgemäß erhaltenes C-basierendes Pyrolyseprodukt enthält Kohle, insbesondere mit Graphitanteilen und in der speziellen Ausführungsform auch mit Siliciumoxidanteilen. Optional enthält das Pyrolyseprodukt Anteile an anderen Kohlenstoffformen, wie Koks, und ist besonders arm an Verunreinigungen, wie z. B. B-, P-, As- und Al-Verbindungen. Ganz besonders bevorzugt entspricht das Verunreinigungsprofil für Al, B, Ca, Fe, Ni, P, Ti und Zn des Pyrolyseprodukts dem oben für die Graphitformteile definierten Profil.

Als Kohlenhydrat-Komponente setzt man beim erfindungsgemäßen Verfahren bevorzugt Monosaccharide, d. h. Aldosen oder Ketosen, wie Triosen, Tetrosen, Pentosen, Hexosen, Heptosen, besonders Glucose sowie Fruktose, aber auch entsprechende auf besagten Monomeren basierende Oligo- und Polysaccharide, wie Lactose, Maltose, Saccharose, Raffinose, - um nur einige oder deren Derivate zu nennen - bis hin zur Stärke, einschließlich Amylose und Amylopektin, den Glykogenen, den Glycosanen und Fructosanen, - um nur einige Polysaccharide zu nennen -, ein.

Wird ein besonders reines Pyrolyseprodukt benötigt, so wird das erfindungsgemäße Verfahren bevorzugt dahingehend modifiziert, dass man die zuvor genannten Kohlenhydrate durch eine Behandlung unter Verwendung eines Ionenaustauschers zusätzlich reinigt, wobei man das Kohlenhydrat in einem geeigneten Lösemittel, vorteilhaft Wasser, besonders bevorzugt deionisiertes oder VE-Wasser, löst, über eine Säule, diese gefüllt mit einem Ionenaustauscherharz, vorzugsweise einem anionischen oder kationischen Harz, führt, die resultierende Lösung aufkonzentriert, beispielsweise durch Entfernen von Lösemittelanteilen durch Erwärmen - insbesondere unter vermindertem Druck - und das so gereinigte Kohlenhydrat vorteilhaft kristallin gewinnt, beispielsweise durch Kühlen der Lösung und anschließender Abtrennung der kristallinen Anteile, u. a. mittels Filtration oder Zentrifuge. Dem Fachmann sind verschiedene Ionenaustauscher zur entfernung unterschiedlicher Ionen bekannt. Es können grundsätzlich so viele Ionenaustauscherschritte hintereinander geschaltet werden bis die gewünschte Reinheit des Zuckerlösung erreicht ist. Alternativ zur Aufreinigung über Ionenaustauscher können jedoch auch andere dem Fachmann bekannte Maßnahmen ergriffen werden um die Kohlenhydratedukte zu reinigen. Beispielsweise seien hier genannt: Zugabe von Komplexbildnern, elektrochemische Aufreinigungsmethoden, Chromatographische Methoden.

Man kann aber auch ein Gemisch aus mindestens zwei der zuvor genannten Kohlenhydrate als Kohlenhydrat bzw. Kohlenhydratkomponente beim erfindungsgemäßen Verfahren einsetzen. Besonders bevorzugt man beim erfindungsgemäßen Verfahren einen in wirtschaftlichen Mengen verfügbaren kristallinen Zucker, einen Zucker, wie er beispielsweise durch Kristallisation einer Lösung bzw. einem Saft aus Zuckerrohr oder Rüben in an sich bekannter Weise gewonnen werden kann, d. h. handelsüblicher kristalliner Zucker, beispielsweise Raffinade-Zucker, vorzugsweise einen kristallinen Zucker mit dem stoffspezifischen Schmelzpunkt/Erweichungsbereich sowie einer mittleren Partikelgröße von 1 µm bis 10 cm, besonders bevorzugt von 10 µm bis 1 cm, insbesondere von 100 µm bis 0,5 cm. Die Bestimmung der Partikelgröße kann beispielsweise - aber nicht ausschließlich - mittels Siebanalyse, TEM, REM oder Lichtmikroskopie erfolgen. Man kann aber auch ein Kohlenhydrat in gelöster Form einsetzen, beispielsweise - aber nicht auschließlich - in wässriger Lösung, wobei das Lösemittel vor Erreichen der eigentlichen Pyrolysetemperatur freilich mehr oder weniger zügig verdunstet. Ganz besonders bevorzugt entspricht das Verunreinigungsprofil für Al, B, Ca, Fe, Ni, P, Ti und Zn der Kohlenhydratkomponente dem oben für die Graphitformteile definierten Profil.

Siliciumoxid bedeutet im Rahmen der vorliegenden Erfindung bevorzugt SiOₓ mit x = 0,5 bis 2,5, bevorzugt SiO, SiO₂, Siliciumoxid(hydrat), wässriges bzw. wasserhaltiges SiO₂, in Form von pyrogener oder gefällter Kieselsäure, feucht, trocken oder kalziniert, beispielsweise Aerosil^{®} oder Sipernat^{®}, oder ein Kieselsäure-Sol bzw. -Gel, poröses oder dichtes Kieselsäureglas, Quarzsand, Quarzglasfasern, beispielsweise Lichtleitfasern, Quarzglasperlen, oder Mischungen aus mindestens zwei der zuvor genannten Komponenten. Ganz besonders bevorzugt handelt es sich um ein Siliciumdioxid.

Bevorzugt verwendet man beim erfindungsgemäßen Verfahren Siliciumdioxide mit einer inneren Oberfläche von 0,1 bis 600 m²/g, besonders bevorzugt von 10 bis 500 m²/g, insbesondere von 50 bis 400 m²/g. Die Bestimmung der inneren bzw. speziellen Oberfläche kann beispielsweise nach dem BET-Verfahren erfolgen (DIN ISO 9277).

Bevorzugt setzt man Siliciumdioxide mit einer mittleren Teilchengröße von 10 nm bis 1 mm, insbesondere von 1 bis 500 µm, ein. Auch hier kann die Bestimmung der Teilchengröße u. a. mittels TEM (Transelektronenmikroskopie), REM (Rasterelektronenmikroskopie) oder Lichtmikroskopie erfolgen.

Das beim erfindungsgemäßen Verfahren verwendete Siliciumoxid weist vorteilhaft eine hohe (99 %) bis höchste (99,9999 %) Reinheit auf, wobei der Gehalt an Verunreinigungen, wie B-, P-, As- sowie Al-Verbindungen, in Summe vorteilhaft ≤ 10 Gew.-ppm, insbesondere ≤ 1 Gew.-ppm, sein sollte. Speziell bevorzugt weist das verwendete Siliciumdioxid für Al, B, Ca, Fe, Ni, P, Ti und Zn ein Verunreinigungsprofil aus, das dem oben für die Graphitformteile definierten Profil entspricht.

In der speziellen Ausführungsform des erfindungsgemäßen Verfahrens kann Kohlenhydrat zu Entschäumer, d. h. Siliciumoxidkomponente, gerechnet als SiO₂, in einem Gewichtsverhältnis von 1 000 : 0,1 bis 0,1 : 1 000 eingesetz werden. Bevorzugt kann man das Gewichtsverhältnis Kohlenhydratkomponente zu Siliciumoxidkomponente auf 800 : 0,4 bis 1 : 1, besonders bevorzugt auf 500 : 1 bis 100 : 13, ganz besonders bevorzugt auf 250 : 1 bis 100 : 7, einstellen.

Die Kohlenhydratkomponente bzw. die Kohlenhydratkomponente und die Silciumoxid-Komponente, können bevorzugt in Pulverform bzw. als Gemisch pyrolysiert werden. Es ist aber auch möglich das Kohlenhydrat bzw. das Gemisch aus Kohlenhydrat und Siliciumoxid vor der Pyrolyse einem Formgebungsprozeß zu unterziehen. Hierzu sind alle dem Fachmann bekannten Formgebungsprozesse anwendbar. Geeignete Verfahren wie z. B. Brikettierung, geeignete Verfahren wie Extrusion, Pressen, Tablettieren, Pelletieren, Granulierung sowie weitere an sich bekannt Verfahren sind dem Fachmann hinlänglich bekannt. Um stabile Formkörper zu erhalten kann z. B. Kohlenhydratlösung oder Melasse oder Ligninsulfonat oder Pentalauge (Abfalllauge aus der Pentaerythrit-Herstellung) oder Polymerdispersionen wie z. B. Polyvinylalkohol, Polyethylenoxid, Polyacrylat, Polyurethan, Polyvinylacetat, Styrolbutadien, Styrolacrylat, Naturlatex, oder Gemische davon als Binder zugesetzt werden, vorzugsweise werden hochreine Binder verwendet.

Als Apparatur für die Durchführung des Pyrolyseschritts des erfindungsgemäßen Verfahrens kann man beispielsweise einen induktionsbeheizten Vakuumreaktor verwenden, wobei der Reaktor in Edelstahl ausgeführt sein kann sowie hinsichtlich der Reaktion mit einem geeigneten Inertstoff belegt bzw. ausgekleidet ist, beispielsweise hochreines SiC, Si₃N₃, hochreines Quarz- bzw. Kieselsäureglas, hochreiner Kohlenstoff bzw. Graphit, Keramik. Man kann aber auch andere geeignete Reaktionsbehältnisse verwenden, beispielsweise einen Induktionsofen mit Vakuumkammer zur Aufnahme entsprechender Reaktionstiegel bzw. -wanne. Im Allgemeinen führt man den Pyrolyseschritt des erfindungsgemäßen Verfahrens wie folgt aus:

Das Reaktorinnere sowie das Reaktionsgefäß werden geeigneterweise getrocknet und mit einem Inertgas, das beispielsweise auf eine Temperatur zwischen Raumtemperatur und 300 °C erwärmt sein kann, gespült. Anschließend füllt man das zu pyrolysierende Kohlenhydrat bzw. Kohlenhydratgemisch bzw. in der speziellen Ausführungsform zusätzlich das Siliciumoxid als Entschäumerkomponente, als Pulver oder als Formkörper, in den Reaktionsraum bzw. das Reaktionsgefäß der Pyrolyseapparatur. Zuvor kann man die Einsatzstoffe innig mischen, unter vermindertem Druck entgasen und unter Schutzgas in den vorbereiteten Reaktor überführen. Dabei kann der Reaktor bereits leicht vorgeheizt sein. Anschließend kann man die Temperatur auf die gewünschte Pyrolysetemperatur kontinuierlich oder stufenweise vorfahren und den Druck verringern, um die aus dem Reaktionsgemisch entweichenden, gasförmigen Zersetzungsprodukte möglichst zügig abführen zu können. Dabei ist es insbesondere durch den Zusatz von Siliciumoxid von Vorteil, eine Schaumbildung des Reaktionsgemisches weitestgehend zu vermeiden. Nach Beendigung der Pyrolysereaktion kann man das Pyrolyseprodukt einige Zeit thermisch nachbehandeln, vorteilhaft bei einer Temperatur im Bereich von 1 000 bis 1 500°C.

In der Regel erhält man so ein Pyrolyseprodukt bzw. eine Zusammensetzung, die hochreinen Kohlenstoff enthält.

Weiterhin kann das Pyrolyseprodukt ein Verhältnis von Kohlenstoff zu Siliciumoxid (gerechnet als Siliciumdioxid) von 400 zu 0,1 bis 0,4 zu 1 000, vorzugsweise von 400 : 0,4 bis 4 : 10; besonders vorzugsweise von 400 : 2 bis 4 : 1,3; insbesondere von 400 : 4 bis 40 : 7 aufweisen.

Je nach Graphitanteil des Pyrolyseprodukts kann das Pyrolyseprodukt direkt nach dem Fachmann bekannten Verfahren zu Formteilen weiterverarbeitet werden bzw. liegt bei Formgebung vor er Pyrolyse bereits als Formkörper vor.

Es kann notwendig jedoch auch notwendig sein einen Graphitisierungsschritt durchzuführen. Dieser Schritt kann ebenfalls nach dem Fachmann bekannten Methoden durchgeführt werden.

Bevorzugt wird das Pyrolyseprodukt ggf. zusammen mit einem Bindemittel und/oder weiteren Komponenten intensiv und homogen vermischt und einer Formgebung unterzogen. Dabei können alle oben für die Herstellung der Zuckerformteile angegebenen Methoden verwendet werden. Bevorzugt werden in Extrudern oder in isostatischen Pressen oder in Gesenkpressen oder in Strangpressen Grünkörper geformt. Je nach Graphitgehalt des Pyrolyseprodukts erfolgt optional ein Glühen der Grünkörper unter Sauerstoffabschluss bei Temperaturen von 600-1200 °C und/oder eine Graphitisierung im Temperaturbereich von 1800-3000 °C.

Als Bindemittel eignen sich bevorzugt solche, die bei Temperaturen zwischen 300 und 800°C verkokbar sind, z.B. Alginate, Zellulose-Derivate oder andere Kohlenhydrate, bevorzugt Monosaccharide wie Fructose, Glucose, Galactose und/oder Mannose und besonders bevorzugt Oligosaccharide wie Saccharose, Maltose und/oder Lactose, aber auch Polyvinylalkohol, Polyethylenoxid, Polyacrylat, Polyurethan, Polyvinylacetat, Styrolbutadien, Styrolacrylat, Naturlatex, oder Gemische davon oder Organosilane. Bevorzugt werden hochreine Bindemittel eingesetzt, d.h. Bindemittel, die für Al, B, Ca, Fe, Ni, P, Ti und Zn ein Verunreinigungsprofil aufweisen, welches dem oben für die Graphitformteile definierten Profil entspricht.

Die Graphitformteile könnnen zu 30 bis 100 Gew.% aus Graphit bestehen, d.h. das Pyrolyseprodukt muss nicht vollständig graphitisiert sein/werden. Die Graphitformteile als Kohlenstoffquelle ausschließlich das voll oder teilweise graphitisierte Pyrolyseprodukt enthalten, es ist jedoch auch möglich weitere graphitisierte oder nicht graphitisierte Kohlenstoffquellen über den Binder oder über die weiteren Komponenten zuzufügen. Die weiteren Komponenten umfassen somit bevorzugt zumindest eine Kohlenstoffquelle die vom erfindungsgemäßen Pyrolyseprodukt verschieden ist. Dabei kann es sich z. B. um Ruße oder Aktivkohle oder Koksvarianten oder Kohlevarianten oder um Graphite oder andere kohlenstoffverbindungen, die beim Glühen oder beim graphitisieren des Formteils verkoken handeln. Besonders bevorzugt weisen alle bestandteile der Graphitformteile für Al, B, Ca, Fe, Ni, P, Ti und Zn ein Verunreinigungsprofil auf, welches dem oben für die Graphitformteile definierten Profil entspricht.

Bei der Graphitisierung von SiO₂ haltigen Pyrolyseprodukten kann das SiO₂ vollständig oder teilweise mit Kohlenstoff zu SiO bzw. SiC reagieren, so dass man auf diese Weise Produkte erhalten kann, die mit Siliciumoxiden und/oder Siliciumcarbiden dotiert sind.

Bei den Formteilen handelt es sich bevorzugt um Elektroden oder Elektroden bestandteilen oder um Bestandteile des Hochfens, bevorzugt solche bestandteile, die mit der Schmelze in Kontakt kommen.

Zusammenfassend umfasst das erfindungsgemäße Verfahren zur Herstellung von Solarsilicium somit bevorzugt den nachfolgenden Schritt d) und ggf. einen oder mehrere der

Schritte a) bis c) und e) bis f) zumindest einen der folgenden Schritte:
a) Aufreinigen zumindest einer Kohlenhydratlösung bzw. eines Kohlenhydrats wie oben beschrieben.
b) Vermischen zumindest einer Kohlenhydratlösung mit zumindest einem Siliciumoxid, bevorzugt zumindest einem Siliciumdioxid
c) Herstellung von Formteilen aus Kohlenhydrat oder Kohlenhydrat und Siliciumoxid wie oben beschrieben
d) Pyrolyse der Kohlenhydratlösung wie oben beschrieben
e) Herstellung von Formteilen, bevorzugt Elektroden aus dem pyrolysierten Kohlenhxdrat
f) Graphitisierung wie oben beschrieben.

Die Definitionen von metallurgischem und Solarsilicium sind allgemein bekannt. So weist Solarsilicium eine Siliciumgehalt von größer gleich 99,999 Gew.% auf.

Die vorliegende Erfindung wird durch die nachfolgenden Beispiele sowie Vergleichsbeispiele näher erläutert und veranschaulicht, ohne den Gegenstand der Erfindung zu beschränken.

### Beispiele

### Vergleichsbeispiel 1

Handelsüblicher Raffinade-Zucker wurde in einem Quarzglas unter Schutzgas geschmolzen und anschließend auf rund 1 600 °C erhitzt. Dabei schäumte das Reaktionsgemisch stark auf, trat teilweise aus - ebenfalls war Karamellbildung zu beobachten, und das Pyrolyseprodukt blieb an der Wand des Reaktionsgefäßes haften.

### Beispiel 1

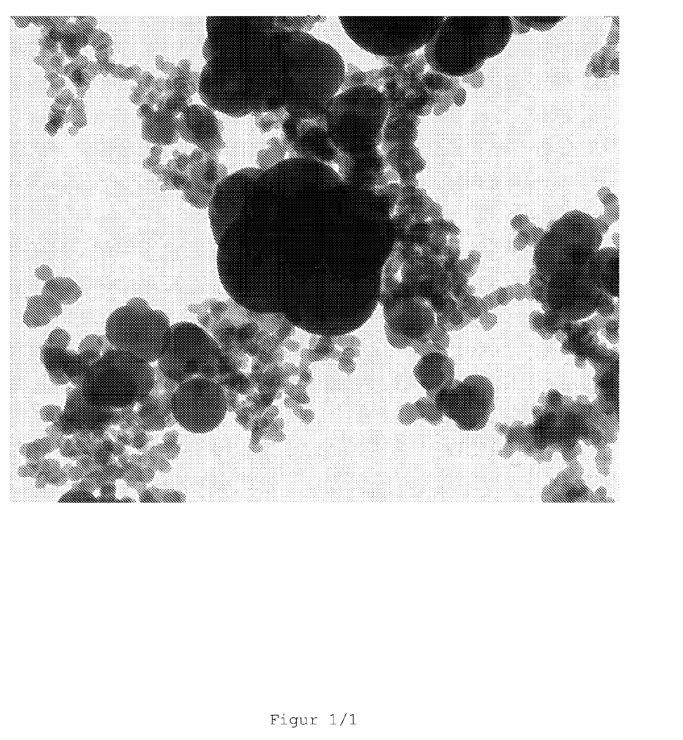

Handelsüblicher Raffinade-Zucker wurde mit SiO₂ (Sipernat^{®} 160) im Gewichtsverhältnis 20 : 1 (Zucker: SiO₂) vermischt, geschmolzen und auf rund 800 °C erhitzt. Dabei wurde keine Karamellbildung beobachtet, auch trat keine Schaumbildung auf. Erhalten wurde ein Graphit-haltiges, partikelförmiges Pyrolyseprodukt, das vorteilhaft im Wesentlichen nicht mit der Wand des Reaktionsgefäßes verhaftet war. Figur 1 zeigt eine elektronenmikroskopische Aufnahme des Pyrolyseprodukts aus Beispiel 1.

## Patentansprüche

1. Verfahren zur Herstellung von Silicium, bevorzugt Solarsilicium durch Reduktion von Siliciumdioxid mit Kohlenstoff, **dadurch gekennzeichnet, dass** es in einem Lichtbogenofen durchgeführt wird und dass zumindest Teile des Ofens oder der Elektroden aus einem Graphitmaterial hergestellt werden, welches wiederum aus einem Kohlenstoffmaterial erhalten wird, welches durch Pyrolyse von zumindest einem Kohlenhydrat, bevorzugt zumindest einem Zucker, gewonnen wird.

2. Verfahren nach Anspruch 1,
**dadurch gekennzeichnet,**
**dass** die Pyrolyse des Kohlenhydrats in Gegenwart zumindest eines Siliciumoxids, bevorzugt einer Siliciumdioxid-Form, besonders bevorzugt einer pyrogenen oder gefällten Kieselsäure oder eines Kieselgels, durchgeführt wird.

3. Verfahren nach Anspruch 1 oder 2,
**dadurch gekennzeichnet,**
**dass** man als Kohlenhydrat-Komponente mindestens einen kristallinen Zucker einsetzt.

4. Verfahren nach einem der Ansprüche 1 bis 3,
**dadurch gekennzeichnet,**
**dass** man Kohlenhydrat und Siliciumoxid (jeweils in Summe gerechnet) in einem Gewichtsverhältnis von 1 000 zu 0,1 bis 0,1 zu 1 000 einsetzt.

5. Verfahren nach einem der Ansprüche 1 bis 4,
**dadurch gekennzeichnet,**
**dass** man die Pyrolyse in einem Reaktor unter Ausschluss von Sauerstoff durchführt.

6. Verfahren nach einem der Ansprüche 1 bis 5,
**dadurch gekennzeichnet,**
**daß** man die Pyrolyse bei einer Temperatur unter 800 °C, bevorzugt bei 300 bis 800 °C, ganz besonders bevorzugt bei 350 bis 700 °C und speziell bevorzugt bei 400 bis 600 °C oder bei einer Temperatur zwischen 800 und 1700 °C, besonders bevorzugt zwischen 900 und 1600 °C, ganz besonders bevorzugt bei 1000 bis 1500 °C und insbesondere bei 1000 bis 1400 °C durchführt.

7. Verfahren nach einem der Ansprüche 1 bis 6,
**dadurch gekennzeichnet,**
**dass** man die Pyrolyse bei einem Druck zwischen 1 mbar und 1 bar und/oder in einer Inertgasatmosphäre durchführt.

8. Verfahren nach einem der Ansprüche 1 bis 7,
**dadurch gekennzeichnet,**
**dass** man das Kohlenhydrat oder ein Kohlenhydratgemisch oder ein Gemisch aus einem Kohlenhydrat und einem Siliciumoxid vor der Pyrolyse einem Formgebungsprozeß, bevorzugt Brikettieren, Extrusion, Verpressen, Tablettieren, Pelletieren, Granulieren unterzieht und den erhaltenen Formkörper pyrolysiert.

9. Verfahren nach einem der Ansprüche 1 bis 8,
**dadurch gekennzeichnet,**
**dass** man das Kohlenhydrat vor der Pyrolyse zumindest einem Aufreinigungsschritt, bevorzugt mittels zumindest eines Ionenaustauschers, unterzieht.

10. Verfahren nach einem der Ansprüche 1 bis 9,
**dadurch gekennzeichnet,**
**dass** die Kohlenhydratkomponenten und oder die Siliciumoxid -komponente in reiner bzw. hochreiner Form eingesetzt wird, bevorzugt mit einem Gehalt an:
a. Aluminium kleiner gleich 5 ppm bevorzugt oder zwischen 5 ppm und 0,0001 ppt, insbesondere zwischen 3 ppm bis 0,0001 ppt, bevorzugt zwischen 0,8 ppm bis 0,0001, ppt, besonders bevorzugt zwischen 0,6 ppm bis 0,0001 ppt, noch besser zwischen 0,1 ppm bis 0,0001 ppt, ganz besonders bevorzugt zwischen 0,01 ppm und 0,0001 ppt, wobei noch bevorzugter 1 ppb bis 0,0001 ppt ist,
b. Bor unter 10 ppm bis 0,0001 ppt, insbesondere im Bereich von 5 ppm bis 0,0001 ppt, bevorzugt im Bereich von 3 ppm bis 0,0001 ppt oder besonders bevorzugt im Bereich von 10 ppb bis 0,0001 ppt, noch bevorzugter im Bereich von 1 ppb bis 0,0001 ppt
c. Calcium kleiner gleich 2 ppm, bevorzugt zwischen 2 ppm und 0,0001 ppt, insbesondere zwischen 0,3 ppm bis 0,0001 ppt, bevorzugt zwischen 0,01 ppm bis 0,0001 ppt, besonders bevorzugt zwischen 1 ppb bis 0,0001 ppt,
d. Eisen kleiner gleich 20 ppm, bevorzugt zwischen 10 ppm und 0,0001 ppt, insbesondere zwischen 0,6 ppm und 0,0001 ppt, bevorzugt zwischen 0,05 ppm bis 0,0001 ppt, besonders bevorzugt zwischen 0,01 ppm bis 0,0001 ppt, und ganz besonders bevorzugt 1 ppb bis 0,0001 ppt;
e. Nickel kleiner gleich 10 ppm, bevorzugt zwischen 5 ppm und 0,0001 ppt, insbesondere zwischen 0,5 ppm und 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt
f. Phosphor kleiner 10 ppm bis 0,0001 ppt, bevorzugt zwischen 5 ppm bis 0,0001 ppt, insbesondere kleiner 3 ppm bis 0,0001 ppt, bevorzugt zwischen 10 ppb bis 0,0001 ppt und ganz besonders bevorzugt zwischen 1 ppb bis 0,0001 ppt
g. Titan kleiner gleich 2 ppm, bevorzugt kleiner gleich 1 ppm bis 0,0001 ppt, insbesondere zwischen 0,6 ppm bis 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt.
h. Zink kleiner gleich 3 ppm, bevorzugt kleiner gleich 1 ppm bis 0,0001 ppt, insbesondere zwischen 0,3 ppm bis 0,0001 ppt, bevorzugt zwischen 0,1 ppm bis 0,0001 ppt, besonders bevorzugt zwischen 0,01 ppm bis 0,0001 ppt und ganz besonders bevorzugt zwischen 1 ppb bis 0,0001 ppt,
und ganz besonders bevorzugt einer Summe der o. g. Verunreinigungen von kleiner 10, bevorzugt kleiner 5 ppm, besonders bevorzugt kleiner 4 ppm, ganz besonders bevorzugt kleiner 3 ppm, speziell bevorzugt 0,5 bis 3 ppm und ganz speziell bevorzugt 1 ppm bis 3 ppm.

11. Graphitformteile, bevorzugt Formteile eines Lichtbogenofens, besonders bevorzugt Graphitelektroden, **dadurch gekennzeichnet, dass** sie mit Silciumoxiden, bevorzugt Siliciumdioxid, und/oder Siliciumcarbid dotiert sind.

12. Graphitformteile nach Anspruch 11,
**dadurch gekennzeichnet,**
**dass** sie das nachfolgende Verunreingungsprofil aufweisen:
a. Aluminium kleiner gleich 5 ppm bevorzugt oder zwischen 5 ppm und 0,0001 ppt, insbesondere zwischen 3 ppm bis 0,0001 ppt, bevorzugt zwischen 0,8 ppm bis 0,0001, ppt, besonders bevorzugt zwischen 0,6 ppm bis 0,0001 ppt, noch besser zwischen 0,1 ppm bis 0,0001 ppt, ganz besonders bevorzugt zwischen 0,01 ppm und 0,0001 ppt, wobei noch bevorzugter 1 ppb bis 0,0001 ppt ist,
b. Bor unter 10 ppm bis 0,0001 ppt, insbesondere im Bereich von 5 ppm bis 0,0001 ppt, bevorzugt im Bereich von 3 ppm bis 0,0001 ppt oder besonders bevorzugt im Bereich von 10 ppb bis 0,0001 ppt, noch bevorzugter im Bereich von 1 ppb bis 0,0001 ppt
c. Calcium kleiner gleich 2 ppm, bevorzugt zwischen 2 ppm und 0,0001 ppt, insbesondere zwischen 0,3 ppm bis 0,0001 ppt, bevorzugt zwischen 0,01 ppm bis 0,0001 ppt, besonders bevorzugt zwischen 1 ppb bis 0,0001 ppt,
d. Eisen kleiner gleich 20 ppm, bevorzugt zwischen 10 ppm und 0,0001 ppt, insbesondere zwischen 0,6 ppm und 0,0001 ppt, bevorzugt zwischen 0,05 ppm bis 0,0001 ppt, besonders bevorzugt zwischen 0,01 ppm bis 0,0001 ppt, und ganz besonders bevorzugt 1 ppb bis 0,0001 ppt;
e. Nickel kleiner gleich 10 ppm, bevorzugt zwischen 5 ppm und 0,0001 ppt, insbesondere zwischen 0,5 ppm und 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt
f. Phosphor kleiner 10 ppm bis 0,0001 ppt, bevorzugt zwischen 5 ppm bis 0,0001 ppt, insbesondere kleiner 3 ppm bis 0,0001 ppt, bevorzugt zwischen 10 ppb bis 0,0001 ppt und ganz besonders bevorzugt zwischen 1 ppb bis 0,0001 ppt
g. Titan kleiner gleich 2 ppm, bevorzugt kleiner gleich 1 ppm bis 0,0001 ppt, insbesondere zwischen 0,6 ppm bis 0,0001 ppt, bevorzugt zwischen 0,1 ppm bis 0,0001 ppt, besonders bevorzugt zwischen 0,01 ppm bis 0,0001 ppt, und ganz besonders bevorzugt zwischen 1 ppb bis 0,0001 ppt.
h. Zink kleiner gleich 3 ppm, bevorzugt kleiner gleich 1 ppm bis 0,0001 ppt, insbesondere zwischen 0,3 ppm bis 0,0001 ppt, bevorzugt zwischen 0,1 ppm bis 0,0001 ppt, besonders bevorzugt zwischen 0,01 ppm bis 0,0001 ppt und ganz besonders bevorzugt zwischen 1 ppb bis 0,0001 ppt.

13. Graphitformteile nach Anspruch 11 oder 12,
**dadurch gekennzeichnet,**
**dass** sei ein Verhältnis von Kohlenstoff zu Silicium (gerechnet als Siliciumdioxid) von 400 zu 0,1 bis 0,4 zu 1 000, besonders bevorzugt von 400 : 0,4 bis 4 : 10; ganz besonders bevorzugt von 400 : 2 bis 4 : 1,3 und insbesondere von 400 : 4 bis 40 : 7 aufweisen.
